# EUROPÄISCHE PATENTSCHRIFT

(11) **EP 1 324 647 B1**
(45) Veröffentlichungstag und Bekanntmachung des Hinweises auf die Patenterteilung: **19.07.2006**
(21) Anmeldenummer: 02026536.9
(22) Anmeldetag: 27.11.2002
(51) Int. Cl.: H05K 7/18

(54) **Einbausatz für Systemträger in Serverracks**
Mounting element for server rack
Element de montage pour un rack de serveur

(30) Priorität: 27.12.2001 DE 10164173
(43) Veröffentlichungstag der Anmeldung: 02.07.2003
(73) Patentinhaber: Fujitsu Siemens Computers GmbH, 80807 München (DE)
(72) Erfinder: Kieneke, Rainer, 33104 Paderborn (DE); Paland, Rolf-Heinrich, 34393 Grebenstein (DE)
(74) Vertreter: Epping - Hermann - Fischer

(56) Entgegenhaltungen:
- EP-A- 0 146 071
- US-A- 4 643 319
- US-A- 5 571 256
- US-A- 6 019 446
- US-A- 6 095 345
- US-A1- 2001 037 985
- US-A1- 2001 040 203

## Beschreibung

Die Erfindung betrifft einen Einbausatz zum Einbau von Systemträgern in Serverschränke wobei quadratische Befestigungslochraster von Vertikalträgern der Serverschränke zur Befestigung der Systemträger dienen.

Serverschränke bestehen unter anderem aus vier Vertikalträgern, die an einer Front und einer Rückseite von Serverschränken in einem definierten Abstand angeordnet sind. Diese Vertikalträger sind an ihren Frontseiten mit einem Befestigungslochraster aus quadratischen Löchern ausgestattet. Dieses Raster ist in allgemeingültige und herstellerunabhängige Höheneinheiten eingeteilt und dient üblicherweise zur Aufnahme von Käfigmuttern, die zur Verschraubung von Frontplatten von Systemkomponenten vorgesehen sind. Serverschränke sind in unterschiedlichen Tiefen erhältlich.

Zur Befestigung von Systemträgern ist üblicherweise ein seitlich in den Vertikalträgern oder in separaten vertikalen Zusatzträgern ein herstellereigenes Lochraster eingebracht. Systemträger sind Gleitschienen, Teleskopschienen oder Geräteböden zur Aufnahme der Systemkomponenten. Die Maße der Lochraster zur Aufnahme der Systemträger variieren von Hersteller zu Hersteller. Nachteilig ist daran, daß für die Befestigung von Systemkomponenten stets herstellerspezifische Systemträger eingesetzt werden müssen. Damit ist eine Standardisierung und Kostenoptimierung nicht möglich.

Aus diesem Grunde wird häufig zur Aufnahme von Systemsträgern das herstellerunabhängige einheitliche Befestigungslochraster aus quadratischen Löchern genutzt. Vorraussetzung dafür sind tiefenvariable Systemträger. Damit ist es möglich einen Systemträger für die Serverschränke verschiedener Hersteller bereitzustellen.

Zur Befestigung der Systemträger in den Serverschränken sind unterschiedliche Befestigungsarten denkbar.

Eine erste denkbare Befestigungsform ist, in das Befestigungslochraster aus quadratischen Löchern eine Käfigmutter einzusetzen und das zu befestigende Bauteil von vorne beziehungsweise von der Front des Vertikalträgers mittels einer Schraube zu befestigen.

Eine zweite denkbare Befestigungsform ist es, den Systemträger an der Rückseite des Befestigunslochrasters aus quadratischen Löchern, mit einer formschlüssigen Schraubverbindung bestehend aus Schraube, Mutter und Zentrier- oder Unterlegscheibe zu befestigen.

Teilweise haben Hersteller von Serverschränken das Bedürfnis, die Systemträger in dem quadratischen Lochraster zu befestigen erkannt und herstellerspezifische Lösungen entwickelt (siehe zum Beispiel US 6 095 345). Die Verwendung dieser Lösungen führt jedoch zu erheblich höheren Kosten als die oben genannten Beispiele

So zeigt Druckschrift US 2001/037985 A1 einen Systemträger für Serverschränke und einen Serverschrank mit einem quadratischen Blechlochraster zur Befestigung des Systemträgers. Der Systemträger weist eine Frontplatte mit Bohrungen auf, welche zur Befestigung des Systemträgers am Serverschrank verwendet werden. Mittels einer geeigneten Schraube und einer Käfigmutter wird der Systemträger mit dem quadratischen Blechlochraster verschraubt. Die Käfigmutter ist gebildet aus einer quadratischen Gewindemutter, welche an zwei gegenüberliegenden Seiten jeweils parallel zur Gewindeachse gerichtete Blechlaschen aufweist, die in einer rechtwinklig abgebogenen U-förmigen Blechnute enden.

Nachteilig für die genannten Einbauvarianten ist, daß zur Durchführung des Einbaus oftmals mehr als eine Person benötigt wird. Ein weiterer Nachteil ist, daß die ersten beiden genannten Einbauvarianten eine äußere Form aufweisen, die das ästhetische Empfinden des Betrachters nicht befriedigt.

Der Erfindung liegt demzufolge die Aufgabe zugrunde, einen Einbausatz bereitzustellen der nicht nur preisgünstig ist, sondern auch das ästhetische Empfinden des Betrachters zufrieden stellt und der es ermöglicht, den Einbau mit nur einer Person durchzuführen.

Diese Aufgabe wird durch die in Patentanspruch 1 dargestellten Maßnahmen gelöst.

Es wird ein rechteckiges Federblech mit einer mittigen Bohrung und zwei gegenüberliegenden Seiten mit jeweils einem 1-förmigen rechtwinklig aufgebogenen Flansch, dessen Enden jeweils nach außen gerichtet sind, in eines der quadratischen Löcher des Befestigunslochrasters eines Vertikalträgers eingebracht und eine Frontplatte eines Systemträgers mit geeigneten Bohrungen für Schraubverbindungen an dem Systemträger angehalten und verschraubt. Dabei kann die Frontplatte ein eigenes unabhängiges Teil oder auch Teil des Systemträgers sein. Das Federblech bleibt dabei während der Montage selbständig in dem quadratischen Loch des Befestigungslochrasters verankert und muß nicht von einem zweiten Mitarbeiter gehalten werden.

An der Rückseite des Befestigungslochrasters des Vertikalträgers wird der Systemträger mit seiner Frontplatte angebracht und von der Frontseite des Vertikalträgers eine Schraube durch das Federblech gesteckt und mit dem Systemträger verschraubt. Dabei ergibt sich durch den Schraubenkopf mit dem Federblech eine formschlüssige Verbindung in dem quadratischen Loch.

Eine weitere Ausgestaltung der Erfindung sieht vor, daß die vorgeschlagene Verbindungsform keine aufbauende Befestigungsart darstellt. Dabei sind die Maße des Federblechs und des Schraubenkopfs mit der Materialstärke des Vertikalträgers an der Stelle der quadratischen Löcher so abgestimmt, daß sich durch Federblech und Schraubkopf kein Überstand, oder nur ein geringer Überstand von ca. 0,2mm, gegenüber der Oberfläche der Frontseite des Vertikalträgers ergibt. Dies beinhaltet einen weiteren Vorteil, nämlich daß Frontplatten von eingebauten Systemkomponenten plan auf der Frontseite des Vertikalträgers aufliegen können und diese dann in einer vertikalen Ebene miteinander fluchten. Besonders bei hochpreisigen Produkten wie voll- oder teilausgestatteten Serverschränken ist der äussere Eindruck ein wichtiges Kriterium.

Im Folgenden wird die Erfindung an einem Ausführungsbeispiel und Figuren näher erläutert.

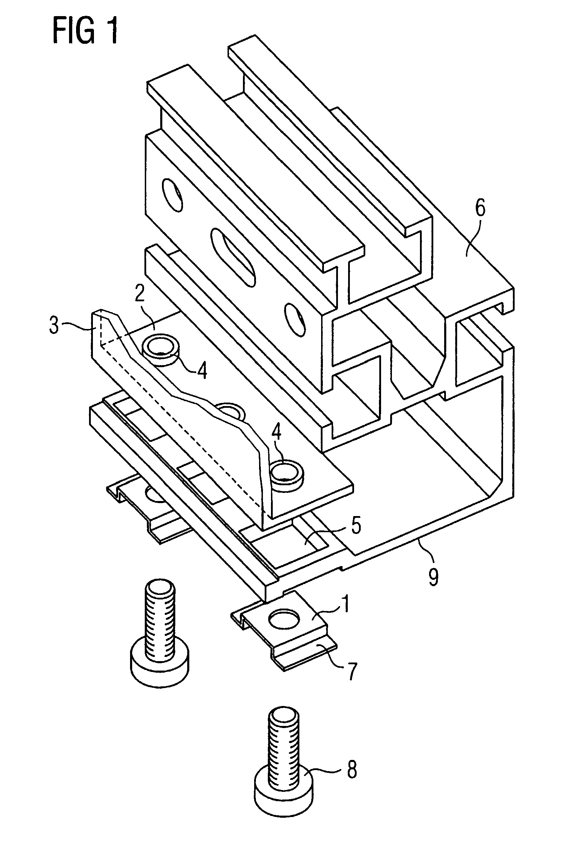

Figur 1 zeigt ein rechteckiges Federblech (1), eine Frontplatte (2) eines Systemträgers (3), nach außen gerichtete Enden (7) eines Federblechs (1), einen Ausschnitt aus einem Vertikalträger (6) eines Serverschrankes und eine geeignete Schraube (8).

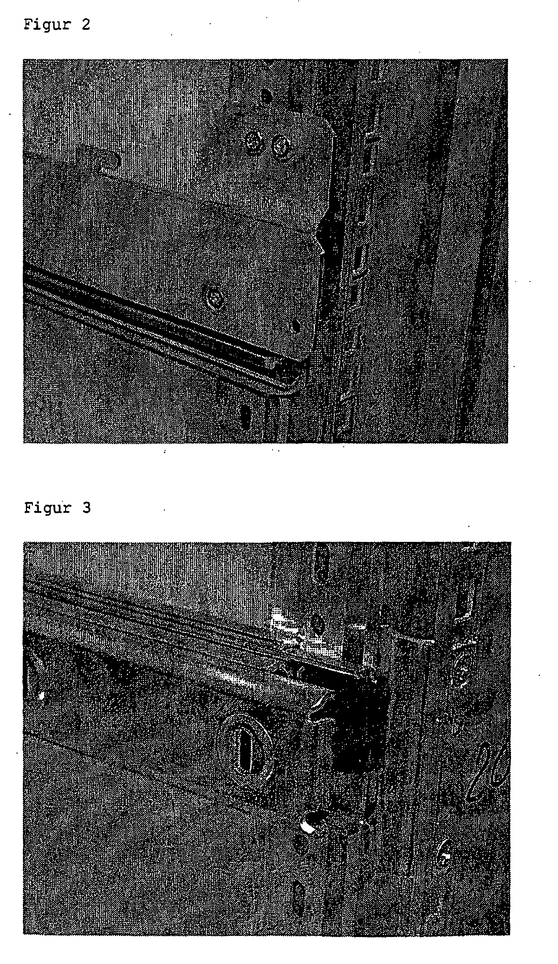

Figur 2 zeigt den Stand der Technik in Form der üblichen Befestigungsweise an den seitlich in den Vertikalträgern vorhandenen herstellerspezifischen Lochraster.

Figur 3 zeigt den Stand der Technik an einer herstellerspezifischen Befestigungsform in dem Befestigungslochraster aus quadratischen Löchern.

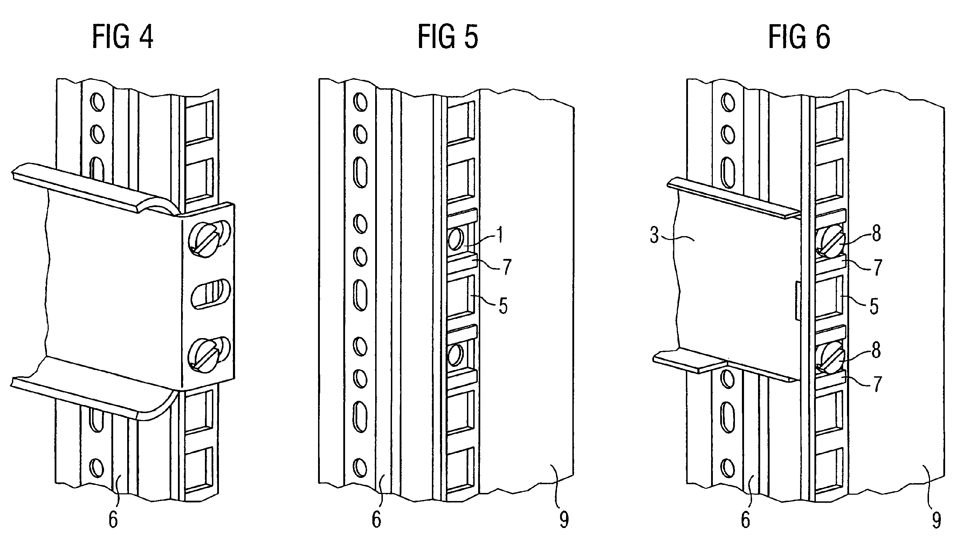

Figur 4 zeigt den Stand der Technik an der Befestigungsform mit Käfigmutter.

Figur 5 zeigt erfindungsgemäß in die quadratischen Bohrungen des Befestigungslochrasters eingebrachte Federbleche (1).

Figur 6 zeigt erfindungsgemäß die formschlüssige Verbindung mittels Schraubenkopf der Schraube (8) und den Enden (7) des Federblechs (1).

In der perspektivischen Darstellung der Figur (1) blickt der Betrachter von unten aus dem Inneren des Schrankes an die Innenseite des Vertikalträgers (6).

Der Aufbau der Schraubverbindung erfolgt in folgender Weise. Zuerst wird das rechteckige Federblech in die quadratisch geformte Aussparung (5) eingebracht, soweit, daß die nach außen gerichteten Enden (7) des Federblechs (1) auf der Oberfläche (9) des Vertikalträgers (6) aufliegen. Im Anschluß daran wird die Frontplatte (2) des Systemträgers (3) an die Rückseite des Vertikalträgers (6) angehalten, dann werden geeignete Schrauben (8) von der Frontseite (9) des Vertikalträgers (6) durch die mittige Bohrung des rechteckigen Federblechs (1) geführt und in den Bohrungen (4) der Frontplatte (2) verschraubt. Wahlweise kann auch eine Schraubenmutter Verwendung finden. Das "System" Schraubenkopf und Federblech (1) ergibt dabei eine formschlüssige Verbindung in der quadratischen Aussparung (5).

## Patentansprüche

1. Einbausatz für einen Systemträger in Serverschränke,wobei quadratische Befestigungslochraster (5) mit quadratisch geformten Aussparungen von Vertikalträgern (6) der Serverschränke zur Befestigung der Systemträger dienen und eine Frontplatte (2, 3) des Systemträgers geeignete Bohrungen in geeignetem Abstand für Schraubverbindungen aufweist, **gekennzeichnet durch**,
ein rechteckiges Federblech (1) mit einer mittigen Bohrung und mindestens zwei gegenüber liegenden Seitenwänden (7) mit jeweils L-förmig rechtwinklig abgebogenen Flanschen, wobei die Enden der Flansche jeweils nach außen gerichtet sind und sich in Verbindung mit einem Schraubenkopf (8) einer geeigneten Schraube mit der rechtwinkligen Aussparung eine formschlüssige Verbindung ergibt.

2. Einbausatz nach Patentanspruch 1, **dadurch gekennzeichnet, daß** das rechteckige Federblech formschlüssig in eine quadratisch geformte Aussparung eines Vertikalträgers eines Serverschranks einsetzbar ist, wobei die beiden nach außen gerichteten Enden die Einbautiefe des Federblechs markieren.

3. Einbausatz nach einem der vorhergehenden Patentansprüche, **dadurch gekennzeichnet, daß** bei der Verwendung in den quadratischen Aussparungen des Vertikalträgers des Serverschranks kein Überstand, oder ein geringst möglicher Überstand, von Federblech oder Schraubenkopf gegenüber der zum Betrachter gerichteten Oberfläche des Vertikalträgers entsteht.

## Claims

1. Mounting kit for a system rack in server cabinets, where square fixing-hole patterns (5) having square shaped cut-outs in vertical mounting racks (6) of the server cabinets are used for fixing the system racks, and a front panel (2, 3) of the system rack has suitable holes at a suitable separation for screw connections,
**characterized by**
a rectangular sprung sheet-steel part (1) having a central hole and at least two opposite side walls (7) each having L-shaped flanges bent at right angles, where the ends of the flange each point outwards, and which in conjunction with a screw head (8) of a suitable screw results in a form-fit connection with the rectangular cut-out.

2. Mounting kit according to Claim 1, **characterized in that** the rectangular sprung sheet-steel part can be inserted with a form fit in a square shaped cut-out of a vertical mounting rack of a server cabinet, where the two outward-pointing ends mark the mounting depth of the sprung sheet-steel part.

3. Mounting kit according to one of the preceding claims, **characterized in that** when used in the square cut-outs of the vertical mounting rack of the server cabinet, no projection, or a minimum projection, of sprung sheet-steel part or screw head is produced with respect to the surface facing the viewer of the vertical mounting rack.

## Revendications

1. Kit de montage pour un support de système dans des baies de serveur, les grilles de trous de fixation carrés (5) munies de creux de forme carré des supports verticaux (6) des baies de serveur servant à la fixation du support de système et une face avant (2, 3) du support de système présentant des perçages appropriés espacés de manière appropriée pour des assemblages vissés, **caractérisé par** une plaquette élastique métallique à effet ressort (1) rectangulaire comprenant un perçage central et au moins deux parois latérales (7) opposées respectivement munies d'une bride pliée à angle droit en forme de L, les extrémités de la bride étant à chaque fois dirigées vers l'extérieur et, en combinaison avec une tête de vis (8) d'une vis appropriée, donnant lieu à une liaison par engagement géométrique avec le creux à angle droit.

2. Kit de montage selon la revendication 1, **caractérisé en ce que** la plaquette élastique métallique à effet ressort peut être introduite par engagement géométrique dans un creux de forme carrée d'un support vertical d'une baie de serveur, les deux extrémités dirigées vers l'extérieur marquant la profondeur d'introduction de la plaquette élastique métallique à effet ressort.

3. Kit de montage selon l'une des revendications précédentes, **caractérisé en ce que** lors de l'utilisation dans les creux carrés du support vertical de la baie de serveur, il ne se produit aucun porte-à-faux, ou un porte-à-faux le plus petit possible, de la plaquette élastique métallique à effet ressort ou de la tête de vis par rapport à la surface du support vertical qui est dirigée vers l'observateur.
